# EUROPEAN PATENT APPLICATION

(11) **EP 3 680 212 A1**
(43) Date of publication of application: **15.07.2020**
(21) Application number: 19151048.6
(22) Date of filing: 09.01.2019
(51) Int. Cl.: B81C 1/00, B01D 67/00, B81B 7/00

(54) **METHOD FOR PRODUCING A PLURALITY OF FILTERS AND MEMS DEVICE HAVING A FILTER**

(71) Applicant: Infineon Technologies AG, 85579 Neubiberg (DE)
(72) Inventor: MEYER, Markus, 93161 Sinzing (DE); WAECHTER, Claus, 93161 Sinzing (DE)
(74) Representative: Pfitzner, Hannes

(57) **Abstract**

A method for producing a plurality of filters comprises the steps:
- providing a base layer;
- nanoimprinting the base layer so as to form an imprinted pattern within the base layer; and
- etching the base layer at least within a portion of the imprinted pattern so as to open the portion of the imprinted pattern and form one or more through hole vias.

## Description

Embodiments disclosed herein refer to a method for producing a plurality of filters. Further embodiments refer to a MEMS device having such a filter.

Some MEMS devices, like microphones, pressure or other environmental sensors, are particle sensitive, especially during the shipment and the assembly process but also during the entire life time. Therefore, the requirement came up to provide a particle barrier (PB). Such a particle barrier can be formed by a filter.

Embodiments provide a method for producing a plurality of filters. The method comprises the following steps:
- providing a base layer;
- nanoimprinting the base layer so as to form an imprinted pattern within the base layers; and
- etching the base layer at least within a portion of imprinted patterns so as to open the portion of the imprinted pattern and form one or more through hole vias.

Teaching disclosed herein are based on the finding that a basis layer, e.g. a base layer, can be perforated using a two-stage process. The first stage comprises the step of nanoimprinting, i.e. a process step using a kind of stamp for imprinting the base. The result of this first stage is an imprinted pattern (i.e. a pattern comprising one or more recesses). Within the second stage, the pattern or at least a part of the pattern (e.g. deep portions / the formed recesses) is opened by a second step of etching. The result of this second stage is a base layer having at least one, but preferably a plurality of through hole vias. This process is beneficial, since a resolution from nm to µm ranges of the imprinted pattern/the through hole vias. Due to the possibility that a plurality of filters can be produced in parallel, a high throughput capability is achieved. For implementing the manufacturing method available tools and materials can be used, so that the method provides several commercial advantages, especially with respect to the implementation efforts.

According to embodiments, the base layer may be a polymer layer. Alternatively, a resist layer may be uses as base layer.

According to a further embodiment, the nanoimprinting can be described in detail as follows. The nanoimprinting comprises - according to an embodiment - imprinting one or more recesses within a first main surface of the base layer so as to form the imprinted pattern within same. The at least one recess is open by etching the first main surface. This etching may result in a removal of the surface material and in a removal of the material within the recesses so that same can be formed to a through hole via/opening to the second main surface (opposite to the first main surface). According to further embodiments, the through hole vias comprise two (different) portions. A first portion (first portions) form the filter structure (e.g. the perforation), while a second portion (second portions) from one or more dicing streets between the plurality of filters.

According to an embodiment, the base layer is provided to a carrier having a release layer in between, such that the base layer is attached with a first main surface to the release layer. It should be noted that according to embodiments, the base layer may be provided using spinning a base material on a carrier having the release layer in between or using laminating a base layer on a release layer of a carrier. Optionally, the method may additionally comprise the following step of removing the release layer after nanoimprinting and/or etching. Starting from this second optional step, a differentiation between two basic cases is made: First, for the bonding of a plurality of filters, the carrier is used to support during the bond process. Removing the base layer is then done after the bond step. According to this first case, the method further comprises bonding the plurality of filters via a second main surface of the plurality of layers on the plurality of functional devices or on a further carrier. Second, the release layer can also be used for supporting a step of picking of single filter elements. According to this variant, the method further comprises the step of picking the single filter elements from a carrier. In this case, the release step is typically done before the picking. Alternatively to the picking of single filter elements from the carrier, a step of bonding a plurality of filter elements can be performed within a common step, e.g. using wafer-to-wafer bonding. Here, a plurality of parallel filters produced by nanoimprinting and etching can be placed in parallel to other devices, like MEMS devices. Typically, the other devices are arranged or formed within another wafer, which can be diced afterwards.

Since typical dicing methods for silicon wafers or other semiconductor wafers are not the preferred variant to dice a base layer, within the method the basic etching step may - according to further embodiments - be performed such that the plurality of filters are separated from each other so that each filter is bonded to the respective functional device (which, vice versa, may be comprised by a non-bonded wafer). After this step of bonding the plurality of filter elements to the respective functional device/the wafer comprising the functional device, the release layer may be removed so as to separate the carrier from the filters. According to further embodiments, the method comprises the step of dicing the wafer after the bonding. Since - as described above - the filters can be separated using the etching step, only the wafer has to be diced to separate the plurality of devices (each comprising a filter bonded to same).

The above-described concept of producing a plurality of filter elements in parallel and bonding the filter elements to a plurality of functional devices (formed on or within a wafer) can be applied to other types of filters. The background thereof is that often the production of filters comprises the step of perforating a basic substrate or providing through hole vias to a basic material. This perforation may, for example, be realized by a conventional lithography process. All these processes enable to form in parallel to the through hole vias dicing streets so as to separate the plurality of filter elements within the same step. Thus, a further embodiment provides a method for producing a plurality of filters, the method comprises the steps of:
- providing a filter layer;
- pattering the filter layer to form a structured pattern, wherein the structured pattern comprises a portion forming filter structures and a further portion forming one or more dicing streets between the plurality of filters; and
- bonding the plurality of filters separated by the one or more dicing streets to a plurality of functional devices formed on or within a wafer via a second surface of the filter layer, wherein the step of bonding the plurality of filters is performed within a common step and/or using wafer-to-wafer bonding.

For this embodiment, it may be noted that optionally, the plurality of filters are attached via a first surface of the filter layer to a release layer of a carrier. Starting from this assumption, the method may further comprise the step of removing the release layer after bonding.

As discussed above, the filter layer may comprise a polymer layer, wherein the structuring is performed using the substeps of nanoimprinting and etching as described above. Alternatively, the filter layer may be a silicon layer or another semiconductor layer.

The above-described method enables to produce MEMS devices having a filter configured to form a particle barrier for a membrane of the MEMS device. Here, it is beneficial that the filter can be formed by a polymer layer having a plurality of through hole vias, wherein the filter does not require a photo-active material. Consequently, an embodiment refers to a MEMS device having a filter, the filter comprising a polymer layer having a plurality of through hole vias, wherein the filter comprises a non-photo-active material. According to an embodiment, the filter layer of the MEMS device comprises additionally to the through hole vias a 3D imprinted structure which can be produced by the nanoimprinting.

Below, embodiments will subsequently be discussed referring to the enclosed figures, wherein
- Fig. 1a: shows a schematic flow chart of a method for manufacturing a plurality of filters according to a basic implementation;
- Fig. 1b: shows a schematic representation of a method for manufacturing a plurality of filters according to an enhanced specification;
- Figs. 2a and 2b: illustrate two different variants of an enhanced method for manufacturing a plurality of filters; and
- Figs. 3a and 3b: show schematic block diagrams for a MEMS device comprising a filter; and
- Fig. 4: shows a schematic flow chart of a method for manufacturing a plurality of filters according to a further embodiment.

Below, embodiments to the present invention will subsequently be discussed referring to the enclosed figures. Here, identical reference numerals are provided to elements or structures having identical or similar function so that the description thereof is mutually applicable or interchangeable.

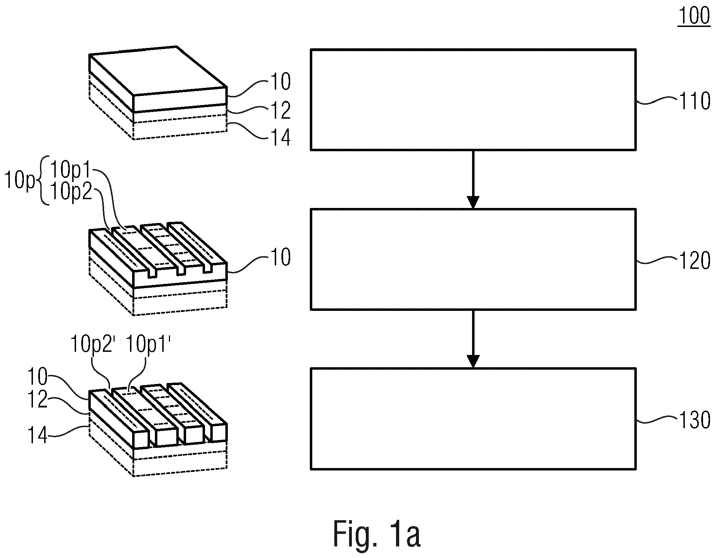

Fig. 1a shows a method 100 for producing a plurality of filters. The method 100 comprises the three basic steps 110, 120 and 130.

In the first basic step 110, a base layer 10, e.g. a polymer layer 10 is provided. Below, the embodiment will be discussed as one having a polymer layer as base layer 10, even if the base layer 10 can be - according to further embodiments - realized differently, e.g. as resist layer. Optionally, the base/polymer layer 10 may be provided arranged on a carrier 14, e.g. a glass substrate, with a release layer 12 in between. Regarding the polymer material, it should be noted that same may be or may comprise a polymethyl acrylate (PMMA) or a polystyrene (PS). Both materials are configured to enable a thermal curing. Alternatively, UV curable materials may be used.

Within the next step 120, a nanoimprinting of the polymer layer 10 is performed. This nanoimprinting may also be referred to as hot embossing. For this, a stamp having the negative shape of the filter structure is used. This stamp (not shown) is pressed under pressure and temperature to the polymer layer 10 so as to transfer the pattern of the stamp. After that, an optional step of annealing of the polymer layer 10 of the polymer layer 10 may be performed, e.g. by use of an increased temperature or UV light. The result of the imprinting 120 is an imprinted pattern 10p. According to embodiments, the imprinted pattern 10p within the polymer layer 10 comprises one or more recesses as illustrated by the side-cut of the polymer layer 10. According to embodiments, the imprinted pattern 10p can be subdivided into two portions, namely portion 10p1 and a portion 10p2. The portion 10p1 may have the shape of holes extending from the main surface of the polymer layer 10 into same to a certain depth which is smaller than the thickness of the polymer layer 10. Expressed in other words, this means that the portion 10p1 forms blind holes which are distributed along the first main surface of the polymer layer 10. This first portion 10p1 forms filter structures after opening same in the following step 130. The second portion 10p2 has the shape of a trench and forms (after opening same by the subsequent step 130) a dicing street separating two filter elements.

The step 130 comprises etching, at least of the imprinted pattern. Background for performing the second step 130 is that the imprinting could not generate through hole vias. At the transition from the polymer layer 10 and the carrier system 12 +14, there is a rest of the polymer material. Within the step 130, the first main surface of the polymer layer 10 may be etched together with the bottom of the trenches/pattern 10p so as to open the pattern 10p and form through hole vias extending from the first main surface to the opposite main surface. Here, both the portion 10p1 as well as the portion 10p2 may be opened by the etching 130. The first portion 10p1' forms the filter structures, e.g. a perforation of the polymer layer 10 and the filter structure, respectively. The sizes of the through hole vias forming the filter structure may, for example, be selected such that small particles can be kept out, while the openings are large enough for the respective application. For example, in case of a filter for a microphone, the through hole vias have to be large enough to enable an airflow or flow of the surround medium carrying the sound wave. Expressed in other words, this means that the size should be selected such that the application of the measurement to the measurement device, e.g. the membrane, is ensured. The second portion 10p2' forms dicing streets between the single filter elements. Here, the resulting filter elements are marked by the reference numeral 1a, 1b, 1c and 1d. It should be noted that the optional carrier 14 helps to enable that the filters 1a to 1b remain at their position after inserting the dicing streets 10p2' into the polymer layer 10. In detail, the filters 1a, 1b, 1c and 1d are still attached to the carrier 14 via the release layer 12.

It should be noted that providing the dicing streets 10p2' is an optional feature of the method 100, which can be achieved by a special implementation of the two steps 120 and 130.

With respect to step 130 it should be noted that the etching may be performed by dry etching (like plasma etching) or by wet etching. The etching 130 may be performed directly subsequent to the step 110, after the annealing, or according to further embodiments, after releasing the polymer layer 10 from the carrier 14, e.g. by removing the release layer 12. For this variant, it is beneficial that the rest of the release layer 12 and the rest of the polymer within the pattern may be removed within a common step.

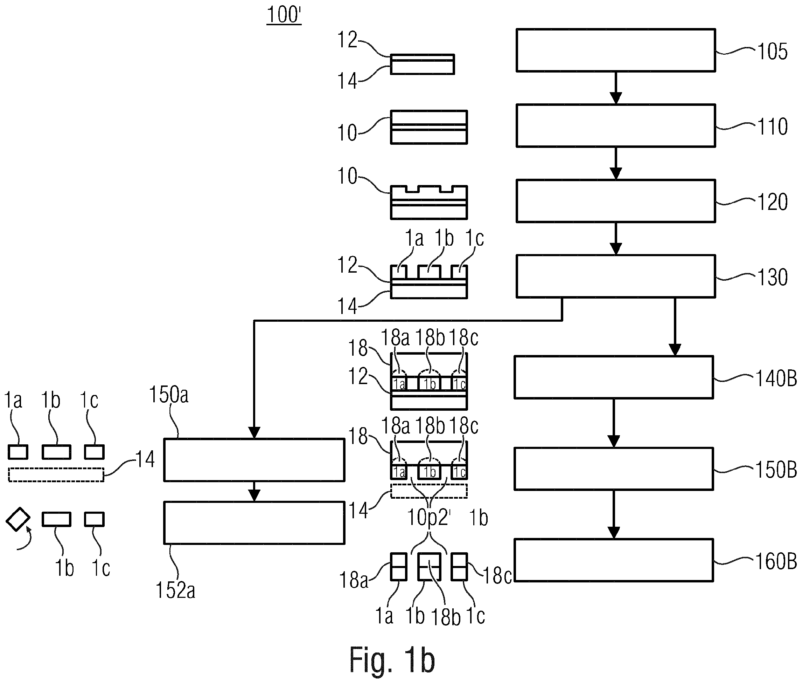

Fig. 1b shows an enhanced variant of the method 100, namely the method 100'. The method 100' comprises the basic steps 110, 120 and 130 as already discussed in context of Fig. 1a.

Additionally, the method comprises a step 105 performed before performing the step 110. Within the step 105, which is an optional step, a carrier 14 or preferably a carrier comprising a release layer 12 is provided and the polymer layer 10 is formed on the release layer 12. For example, the forming of the polymer layer 10 may be done using spin coating or by laminating the polymer layer 10 on the release layer 12. The result is that the polymer layer 10 is provided (see step 110). Subsequent to the step 130, there are two possibilities. Both of the possibilities start with the assumption that the filter elements 1a, 1b and 1c are attached to the release layer 12 such that all filter elements can be handled together.

According to a first variant, the release layer 12 is removed within a step 150A, which enables that the elements 1a, 1b and 1c are no longer connected to the carrier 14. For example, the releasing may be performed by using a laser which is configured to remove the release layer 12. Alternatively, an etching or another release procedure may be performed. After the release, an optional step of picking may be performed. This optional step is marked by the reference numeral 152A. Alternatively, the release layer 12 may be removed using high temperatures. The result of the picking step 152A is that a plurality of singulated filter elements 1a to 1c are available.

According to a second variant, a wafer-to-wafer bonding may be performed subsequent to the step 130. This step of wafer bonding is marked by the reference numeral 140B. Here, an additional wafer 18, e.g. a semiconductor substrate comprising a plurality of devices like MEMS devices may be attached to the first main surface of the polymer layer (rest of the polymer layer 10) such that the semiconductor substrate 18 is in direct contact with the filters 1a, 1b and 1c. Preferably, the filters 1a, 1b and 1c are positioned at the corresponding target position which depends on the functional device (cf. 18a, 18b and 18c of the substrate 18). For example, the functional devices 18a, 18b and 18c may be MEMS devices having a membrane, wherein the filter 1a, 1b and 1c are attached to the devices 18a, 18b and 18c so as to cover the membrane of the MEMS devices 18a, 18b and 18c. In order to achieve that the filters 1a, 1b and 1c are aligned to the functional elements 18a, 18b and 18c, the layout of the nanoimprinting and etching is adapted to the layout of the functional devices 18a to 18c formed within or on the wafer 18. Preferably, this step 140B comprises a wafer-to-wafer bonding.

Subsequent to the step 140B, another step 150B is performed. In this step 150B, the release layer 12 is removed such that the filter elements 1a, 1b and 1c are no longer connected to the carrier 14.

According to a further embodiment, the wafer 18 is diced (cf. step 160B). The dicing is preferably performed within the dicing streets 10p2' so that the MEMS devices 18a, 18b and 18c with their filters 1a, 1b and 1c are singulated.

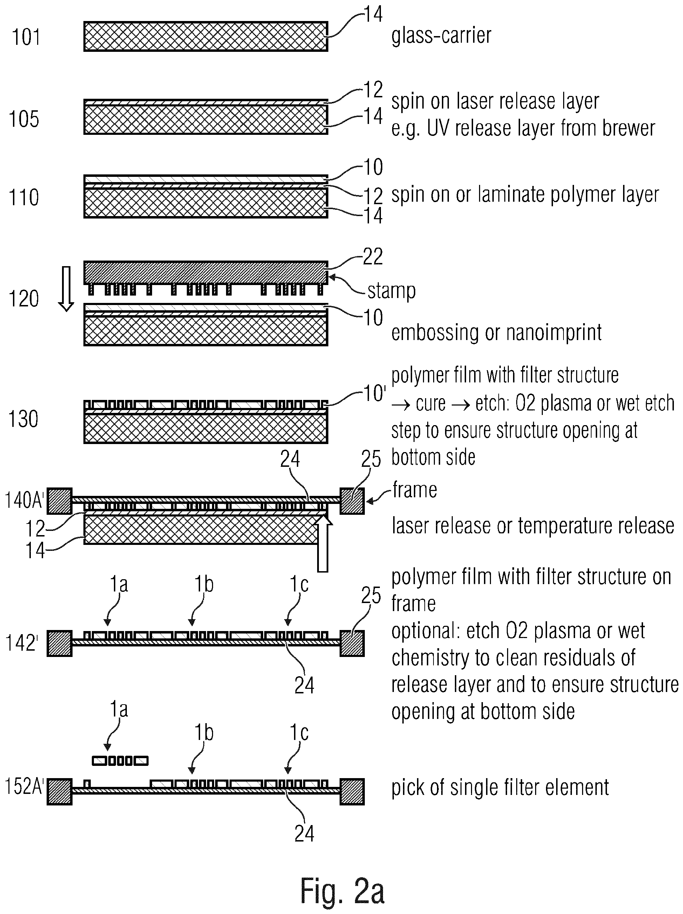

With respect to Fig. 2a, the manufacturing process 100" will be discussed in much detail. The process 100" comprises, for example, nine steps, 101 to 160B' or 152A'. Within the first step 101, a carrier 14, e.g. a glass carrier is provided. Within the next step 105, the release layer 12 is formed on the carrier 14. This may be performed by spin on laser release layer, e.g. UV release layer from Brewer. After that, the polymer layer 10 is formed on the release layer 12, e.g. also by spin on or laminating (cf. step 110).

After that, a stamp 22 is used to nanoimprint/emboss the polymer layer 10 (cf. step 120). This step is comparable to the implementations as described in the context of Fig. 1a and Fig. 1b. Analogously to Fig. 1a and 1b, the polymer film with filter structures is etched, e.g. after curing (cf. step 130). For example, O2 plasma or wet etching is used to ensure structure opening at the bottom side. In this implementation of the method 100", a membrane 24 carried by a frame 25 is attached to the structured polymer layer 10' (cf. step 140A') to support the singulated filters 1a, 1b and 1c after release layer 12 and the carrier 14, respectively.

The removing of the release layer 12 is performed e.g. by laser release or temperature release during the subsequent step 140A' and has the aim to separate the structured polymer layer forming the filter from the carrier 14. The result is shown with respect to the step 142' showing a polymer film with filter structures 1a, 1b and 1c on the frame 25/the membrane 24. Optionally, the removing 140A' may comprise an etching like O2 plasma etching or wet chemistry etching may be performed to clean residuals of the release layer and/or to ensure structure opening at the bottom side.

According to a further embodiment, the filter elements 1a, 1b, 1c attached to the membrane 24 can be picked as single filter elements, since a portion of the embossed and etched pattern enables that the filter elements are singulated from each other. The step of picking single filter elements is marked by the reference numeral 152A'.

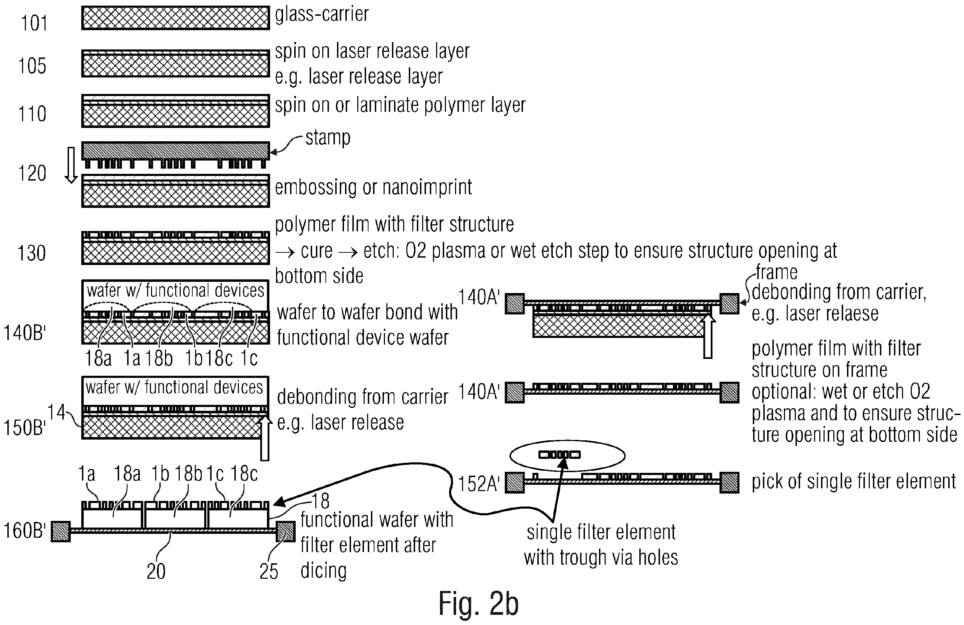

Fig. 2b shows another variant of the method, namely the method 100"'. The method 100'" comprises the steps 101, 105, 110, 120 and 130. Subsequent to the step 130, the two variants A and B are shown. The variant B comprising the steps 140A', the result of the step 140A' and the step 152A' is shown for comparison reasons on the right side. Within the process flow of the method 100"', the step 140B" of wafer-to-wafer bonding, e.g. with a functional device wafer marked by the reference numeral 18. As illustrated, the wafer 18 comprises a plurality of functional devices marked by the reference numerals 18a, 18b and 18c. With respect to the wafer sizes of the carrier 14 and the wafer 18, it should be noted that same may preferably, but not necessarily, have the same size in order to enable a good alignment. The size may, for example, be in the range of 200 or 300 mm.

After the step 140B', a de-bonding from the carrier 14 is performed within the step 150B'. Here, laser release or another technique may be used. The result is that the functional elements 18a, 18b and 18c are aligned to the respective filter elements 1a, 1b and 1c. This result is illustrated with respect to the step 160B'. The optional step of 160B' refers to the dicing of the functional wafer 18, e.g. the dicing streets defined between the filter elements 1a, 1b and 1c. For the dicing, the functional wafer 18 may be attached to a membrane 24 carried by a frame 25.

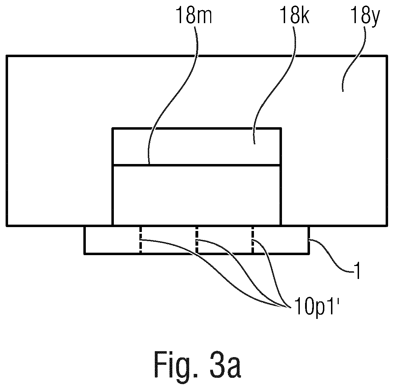

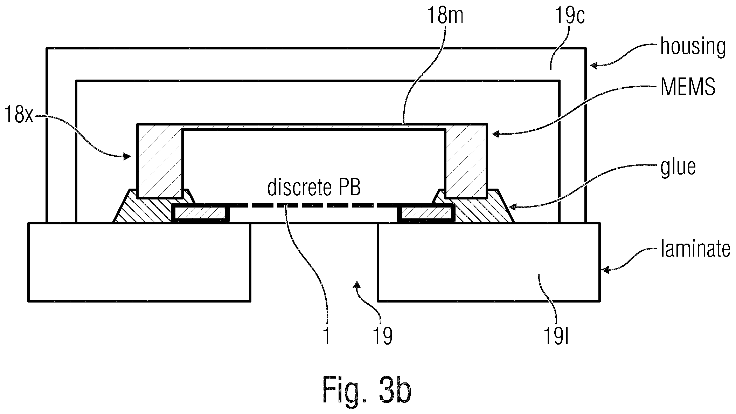

With respect to Figs. 3a and 3b two MEMS devices 18x are combined with a filter 1, e.g. manufactured as described above.

Fig. 3a shows a MEMS device 18y having a cavity 18k within which a membrane 18m is arranged. Additionally, a filter 1 is attached to the MEMS device 18y, e.g. from the side at which the cavity 18k is provided. The filter 1 is attached to the MEMS device 18 such that the membrane 18m is covered. As illustrated by use of the reference numerals 10p1', the filter 1 has a plurality of through hole vias enabling to allow a physical signal passing through the filter 1 to the membrane 18m. The physical signal may, for example, be a sound wave. The size of the through hole vias 10p1' may amount to 100 µm or 1 nm. In general, the size is in the range between 100 µm and 10 nm or in the range between 50 µm and 20 nm. Preferably, the size of each through hole 10p1' may be in the range between 200 µm and 1 nm. The size differs with respect to the application.

Fig. 3b shoes a filter 1 connected to the MEMS device 18x using a glue which mainly has the purpose to attach the MEMS device 18x to a laminate 191. Here, the filter 1 is aligned to a hole and arranged such that same capsulates the MEMS device 18x to the outside opening 19. Furthermore, the filter 1 is aligned to a membrane 18m of the MEMS device 18x. It should be noted that in this implementation, the MEMS device 18x is arranged within a housing which is formed by the laminate 191 and the cover 19c.

The filters produced using nanoimprinting/hot embossing in combination with etching enables to be used in the technical field of microfluidics, wafer level optics or biosensorics.

According to embodiments, the filters may have a 3D structure, i.e. formed by trenches or blind holes. These structures can be used for the above-described applications, e.g. for microfluidics.

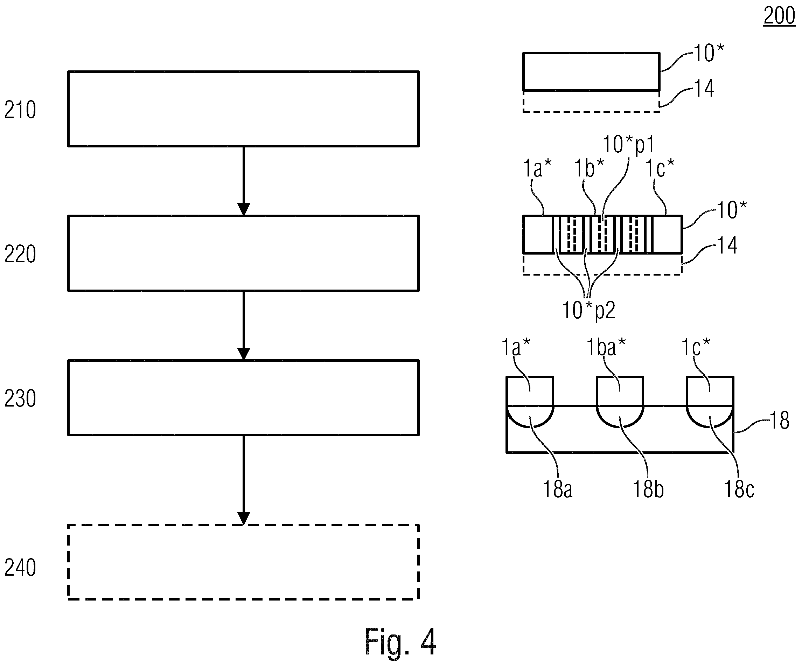

According to above-described embodiments, the filters may be structured using the combination of nanoimprinting and etching. Here, it is beneficial, according to further embodiments, that a dicing of the produced filter elements can be achieved in parallel to the structuring. According to another aspect, this perforation may also be performed when other techniques for structuring devices, e.g. structuring filter elements, are performed. Therefore, a further embodiment provides the method as illustrated by Fig. 4.

Fig. 4 shows the method 200 of producing a plurality of filter elements. The method 200 comprises the three basic steps 210, 220 and 230.

In the first step 210, a filter layer 10* is provided, e.g. on a carrier 14 (having a release layer in between).

Within the next step 220, the filter layer 10* is patterned, e.g. using conventional lithography or using the above-described method being based on the combination of nanoimprinting and etching. Due to the pattering of the method step 220, two different portions 10*p1 and 10*p2 are inserted into the filter layer 10*. The first portion 10*p1 refers to the filter structure, i.e. to the perforation, while the second portion 10*p2 forms the dicing streets enabling to separate the different filter elements from each other during the pattering step.

When the filter layer 10* is attached to the carrier 14, the different filter elements 1a*, 1b* and 1c* still remain at their positions.

Subsequent to the step 220, a bonding, e.g. a wafer-to-wafer bonding, is performed. Here, the plurality of filters 1a*, 1b* and 1c* are bonded to a wafer 18, e.g. a wafer having a plurality of functional devices 18a, 18b and 18c. According to further embodiments, the bonding is performed such that the filter elements 1a*, 1b* and 1c* are aligned to the functional devices 18a, 18b and 18c.

As discussed above, the method may be enhanced by a step 240 of dicing the functional device 18 so as to separate the functional devices 18a, 18b and 18c each having a filter element 1a*, 1b* and 1c*.

Embodiments described herein are just for illustration purpose, wherein the scope of protection is defined by the following claims.

**List of reference numerals**

| | |
|---|---|
| Filters | 1a, 1b, 1c |
| Polymer layer | 10 |
| Imprinted pattern | 10p |
| Through hole vias | 10p1', 10p2' |
| Recess | 10p1, 10p2 |
| Filter structures | 10p1 |
| Dicing streets | 10p2 |
| Carrier | 14 |
| Release layer | 12 |
| Further carrier | 24 |
| Wafer | 18 |
| Functional devices | 18a, 18b, 18c |
| MEMS device | 18* |
| Filter | 1 |
| Membrane | 18m |

## Claims

1. A method for producing a plurality of filters (1a, 1b, 1c), the method comprising the steps:
providing (110) a base layer (10);
nanoimprinting (120) the base layer (10) so as to form an imprinted pattern (10p) within the base layer (10); and
etching (130) the base layer (10) at least within a portion of the imprinted pattern (10p) so as to open the portion of the imprinted pattern (10p) and form one or more through hole vias (10p1', 10p2').

2. The method according to claim 1, wherein nanoimprinting (120) comprises imprinting one or more recesses (10p1, 10p2) within a second main surface of a base layer (10) so as to form the imprinted pattern (10p), wherein at least one recess (10p1, 10p2) is opened by the etching (130) the first main surface of the base layer (10).

3. The method according to one of the previous claims, wherein the through hole vias (10p1', 10p2') comprise a first portion forming filter structures (10p1) and comprise a second portion forming one or more dicing streets (10p2) between the plurality of filters (1a, 1b, 1c).

4. The method according to one of the previous claims, wherein the base layer (10) is provided (110) to a carrier (14) having a release layer (12) in between, such that the base layer (10) is attached with a first main surface to the release layer (12); and/or
wherein the base layer (10) is provided (110) on a carrier (14) having a release layer (12) in between, such that the base layer (10) is attached with a first main surface to the release layer (12) and wherein the method further comprises the step of removing the release layer (12) after nanoimprinting (120) and/or etching (130), especially after bonding or before picking.

5. The method according to one of the previous claims, wherein the method further comprises bonding the plurality of filters (1a, 1b, 1c) via a second main surface of the base layer (10) on the plurality of functional devices (18a, 18b, 18c) or on a further carrier (24).

6. The method according to claim 5, wherein the method further comprises the step of picking the single filters (1a, 1b, 1c) from a carrier (14).

7. The method according to claim 5, wherein the step of bonding the plurality of filters (1a, 1b, 1c) is performed within a common step and/or using wafer to wafer bonding.

8. The method according to claim 5, 6 or 7, wherein the etching (130) is performed, such that the plurality of filters (1a, 1b, 1c) are separated from each other, so that each filter is bonded to a respective functional device.

9. The method according to claim 5, 7 or 8, wherein a release layer (12) via which the plurality of filters or separated filters (1a, 1b, 1c) are attached to a carrier (14) is removed after bonding.

10. The method according to one of claims 5, 7, 8 or 9, wherein the plurality of functional devices (18a, 18b, 18c) are formed within or on a wafer (18) and wherein the method further comprises the step of dicing the wafer (18) after bonding.

11. The method according to one of the previous claims, wherein providing (110) a base layer (10) is performed using spinning on a polymer material on a carrier (14) having a release layer (12) or using laminating a base layer (10) on a release layer (12) of a carrier (14).

12. The method according to one of the previous claims, wherein the base layer (10) is a polymer layer.

13. A method for producing a plurality of filters (1a, 1b, 1c), comprising the steps:
providing (210) a filter layer;
pattering (220) the filter layer to form a structured pattern, wherein the structured pattern comprises a portion forming filter structures (10p1) and a further portion forming one or more dicing streets (10p2) between the plurality of filters (1a, 1b, 1c); and
bonding (230) the plurality of filters (1a, 1b, 1c) separated by the one or more dicing streets (10p2) to a plurality of functional devices (18a, 18b, 18c) formed on or within a wafer (18) via a second surface of the filter layer, wherein the step of bonding (230) the plurality of filters (1a, 1b, 1c) is performed within a common step and/or using wafer to wafer bonding.

14. The method according to claim 13, wherein the plurality of filters (1a, 1b, 1c) are attached via a first main surface of the filter layer to a release layer (12) of a carrier (14); and/or
wherein the plurality of filters (1a, 1b, 1c) are attached via a first main surface of the filter layer to a release layer (12) of the carrier (14) and wherein the method further comprises the step of removing the release layer (12) after bonding.

15. The method according to one of claims 13 to 14, wherein the filter layer comprises a polymer layer (10) and wherein the structured pattern is provided (110) using the substeps nanoimprinting (120) the polymer layer (10) so as to form an imprinted pattern (10p) within the polymer layer (10) and of etching (130) the polymer layer (10) at least within the imprinted pattern (10p) so as to open the imprinted pattern (10p) and from through hole vias (10p1', 10p2').

16. A MEMS device (18*) having a filter (1) configured to form a particle barrier for a membrane (18m) of the MEMS device (18*), the filter (1) comprising a polymer layer (10) having a plurality of through hole vias (10p1', 10p2'), wherein the filter comprises a non-photo-active material.

17. The MEMS device (18*) according to claim 16, wherein the filter (1) comprises a 3D imprinted structure.

## Amended claims

### Amended claims in accordance with Rule 137(2) EPC.

1. A method for producing a plurality of filters (1a, 1b, 1c), the method comprising the steps:
providing (110) a base layer (10);
nanoimprinting (120) the base layer (10) so as to form an imprinted pattern (10p) within the base layer (10); and
etching (130) the base layer (10) at least within a portion of the imprinted pattern (10p) so as to open the portion of the imprinted pattern (10p) and form one or more through hole vias (10p1', 10p2');
wherein the method further comprises bonding the plurality of filters (1a, 1b, 1c) via a second main surface of the base layer (10) on the plurality of functional devices (18a, 18b, 18c) or on a further carrier (24); and
wherein the etching (130) is performed, such that the plurality of filters (1a, 1b, 1c) are separated from each other, so that each filter is bonded to a respective functional device; or wherein a release layer (12) via which the plurality of filters or separated filters (1a, 1b, 1c) are attached to a carrier (14) is removed after bonding; or wherein the plurality of functional devices (18a, 18b, 18c) are formed within or on a wafer (18) and wherein the method further comprises the step of dicing the wafer (18) after bonding.

2. The method according to claim 1, wherein nanoimprinting (120) comprises imprinting one or more recesses (10p1, 10p2) within a second main surface of a base layer (10) so as to form the imprinted pattern (10p), wherein at least one recess (10p1, 10p2) is opened by the etching (130) the first main surface of the base layer (10).

3. The method according to any of the previous claims, wherein the through hole vias (10p1', 10p2') comprise a first portion forming filter structures (10p1) and comprise a second portion forming one or more dicing streets (10p2) between the plurality of filters (1a, 1b, 1c).

4. The method according to any of the previous claims, wherein the base layer (10) is provided (110) to a carrier (14) having a release layer (12) in between, such that the base layer (10) is attached with a first main surface to the release layer (12); and/or
wherein the base layer (10) is provided (110) on a carrier (14) having a release layer (12) in between, such that the base layer (10) is attached with a first main surface to the release layer (12) and wherein the method further comprises the step of removing the release layer (12) after nanoimprinting (120) and/or etching (130), especially after bonding or before picking.

5. The method according to any of the previous claims, wherein the method further comprises the step of picking the single filters (1a, 1b, 1c) from a carrier (14).

6. The method according to any of the claims 1-4, wherein the step of bonding the plurality of filters (1a, 1b, 1c) is performed within a common step and/or using wafer to wafer bonding.

7. The method according to any of the previous claims, wherein providing (110) a base layer (10) is performed using spinning on a polymer material on a carrier (14) having a release layer (12) or using laminating a base layer (10) on a release layer (12) of a carrier (14).

8. The method according to any of the previous claims, wherein the base layer (10) is a polymer layer.
